# EUROPÄISCHE PATENTSCHRIFT

(11) **EP 1 198 613 B1**
(45) Veröffentlichungstag und Bekanntmachung des Hinweises auf die Patenterteilung: **15.01.2003**
(21) Anmeldenummer: 00935126.3
(22) Anmeldetag: 26.05.2000
(51) Int. Cl.: C23C 16/458

(54) **VORRICHTUNG ZUM ROTIEREN EINES MIT KERAMISCHEN UND METALLISCHEN SUBSTANZEN ZU BESCHICHTENDEN SUBSTRATS IN EINEM PROZESSRAUM**
DEVICE FOR ROTATING A SUBSTRATE TO BE COATED WITH CERAMIC AND METALLIC SUBSTANCES IN A PROCESS CHAMBER
DISPOSITIF POUR FAIRE TOURNER UN SUBSTRAT A REVETIR AVEC DES SUBSTANCES CERAMIQUES ET METALLIQUES DANS UNE CHAMBRE DE PROCEDE

(30) Priorität: 10.07.1999 DE 19932338
(43) Veröffentlichungstag der Anmeldung: 24.04.2002
(73) Patentinhaber: Forschungszentrum Karlsruhe GmbH, 76133 Karlsruhe (DE)
(72) Erfinder: RATZEL, Fritz, D-76351 Linkenheim-Hochstetten (DE)
(86) Internationale Anmeldenummer: EP0004821
(87) Internationale Veröffentlichungsnummer: WO01004378

(56) Entgegenhaltungen:
- WO-A-99/27563
- US-A- 5 468 299
- US-A- 5 782 979

## Beschreibung

Die Erfindung betrifft eine Vorrichtung zum Rotieren eines mit Substanzen ein- oder gleichzeitig beidseitig zu beschichtenden Substrats in einem Prozeßraum, in dem die für den Beschichtungsprozeß geeigneten Druck- und Temperaturbedingungen einstellbar sind.

Als Substanzen kommen Hartstoffe wie TiN oder TiC für die Verbesserung der Oberflächehärte von Werkzeugen in Betracht, ebenso metallische Substanzen zur Vergütung einer Oberfläche oder supraleitende. Den aufzutragenden Substanzen muß zu eigen sein, daß sie zerstäubbar sind, damit sie, aus dem Reaktionsraum heraustransportiert, auf dem exponierten Ablageort, dem Substrat, niederschlagen.

In der modernen Nachrichtentechnik werden Filter mit immer steileren Flanken und damit schärferer Trenncharakteristik benötigt, die sich aus mit hochtemperatursupraleitenden Substanzen gleichmäßig beschichteten Substraten ätzen lassen. Ebenso werden Mikrowellenresonatoren hoher Güte benötigt.

Die Thematik Beschichtungsqualität von Substraten wird von namhaften Institutionen engagiert angegangen. Konkurrierende Methoden sind die Laserablation (LA) und das thermische Aufdampfen (TA).

In Proc. Applied Superconductivity Conference 1998, 13. 18. Sep. 1998, Palm Springs, CA, U.S.A. berichten M. Lorenz et al. über Ag-versetzte beidseitige PLD-YBCO Dünnfilme für passive Mikrowellen Baugruppen in zukünftigen Kommunikationssystemen. Über gepulste Laser werden die Dünnfilmschichten auf beiden Seiten eines Saphirwafers,des Substrats, mit 3" Durchmesser abgelegt (LA). Das Substrat wird hierzu in einem nach oben offenen Heizsystem befestigt und rotiert mit demselben.

In IEEE Transactions on appl.Superconductivity, Vol. 7, No. 2. June 1997 berichten B. Utz et al. unter dem Titel "Deposition of YBCO and NBCO Films on Areas of 9 Inches in Diameter" über hochqualitative Y-123 Dünnfilme, die durch reaktive thermische Verdampfung aufgetragen wurden bzw. gewachsen sind. Hierzu wird das Substrat zwischen zwei Heizplatten rotiert. Eine der Heizplatten hat einen Segmentausschnitt durch den hindurch der gerade exponierte Bereich des Substrats beaufschlagt wird (TA). Das Substrats wird über eine verdeckte Welle rotiert, die in der kalten Zone des Prozeßraums gelagert ist und von dort angetrieben wird.

In der DD 224 879 A1 ist ein rotierender, kugelgelagerter Substrathalter, bei dem die Lagerung am Substrathalterschaft angeordnet ist, beschrieben.

Zum beidseitigen Beschichten muß das Substrat bei beiden Verfahren gewendet werden. Das geht nur über eine Belüftung der Anlage, und nach dem Wenden des Substrats muß die Anlage erneut angefahren werden. Die beidseitige Beschichtung ist nur sequentiell durchführbar. Damit aber geht eine leichte Degradation der zuerst beschichteten Seite einher.

In dem Patent Abstracts of Japan, C-654 von der JP 01-205070 A ist ein rotierender, kugelgelagerter Substrathalter zum beidseitigen Beschichten des Substrats, bei dem die Lagerung am Substrathalterschaft angeordnet ist, beschrieben.

Aus der DE 42 34 590 C1 ist eine Vorrichtung zum beidseitigen Aufstäuben von Supraleitermaterial bekannt, wobei das Substrat mittels Drehschieber in eine Doppel-Kreuzkammer zwischen zwei gegenüberliegenden Magnetron-Kathoden angeordnet, dort entlang der Achse des Drehschiebers, die senkrecht zur Achse des Substrats steht, hin und her geschoben und unabhängig davon um diese Achse gedreht oder nur um einen vorgegebenen Winkel weitergedreht wird.

Der Erfindung liegt die Aufgabe zugrunde, eine Vorrichtung zur Rotation von Substraten bereit zu stellen, mit der das Substrat im Prozeßraum mit seinen extremen thermischen und atmosphärischen Bedingungen zum Erreichen einer ausgezeichneten Schichtqualität reibungslos prozessiert werden kann.

Die Erfindung wird durch eine Vorrichtung, die gemäß den Merkmalen des Anspruch 1 aufgebaut ist, gelöst.

Die Vorrichtung besteht im Kern aus einem zweiseitigen Kugellager aus zwei Ringscheiben, zwischen denen sich der ringförmige Substrathalter, durch Kugeln von beiden getrennt, drehen kann. Beide Ringscheiben sind durch Distanzbolzen zueinander auf Distanz gehalten. Die einander zugewandten Stirnflächen der beiden Ringscheiben und des dazwischen liegenden Substrathalters haben je eine gleichartige Ringnut, so daß dies- und jenseits von ihm je ein Laufbett für die eingelegten Kugeln besteht.

Dieses zweiseitige Kugellager befindet sich auf einem Lagerbock. In dem Lagerbock endet eine Antriebswelle, auf der eine Getriebeschnecke, über eine Distanzhülse in Position gehalten, aufsitzt, die in einen auf der Mantelfläche des Substrathalters angebrachten Zahnkranz eingreift, wodurch derselbe die Drehung erfährt.

Im Prozeßraum sind Druckbedingungen von 10⁻⁶ mbar bis Umgebungsdruck und Temperaturen bis 1000°C einstellbar, daher müssen die verwendeten Materialien der Vorrichtung entsprechend mechanisch fest und chemisch inert sein, insbesondere bei reiner Sauerstoffatmosphäre. Schmierung der gegeneinander bewegten Teile der Vorrichtung kann zwecks der Reinhaltung des Prozeßraums nicht vorgenommen werden.

Durch die extremen Temperaturen sind Materialausdehnung und - schrumpfung in die Konstruktion sensibel mit einzubeziehen. Das betrifft insbesondere das Kugellager und den Antrieb des Substrathalters. Durch die Kugeln aus hartem, abriebfestem, bei hoher Betriebstemperatur formbeständigem, schlecht die Wärme leitendem Material wird die Kugellagerfunktion bei allen Prozeßbedingungen zuverlässig aufrecht erhalten, und gleichzeitig ist der Substrathalter durch diese Maßnahme thermisch von den Ringscheiben entkoppelt.

Die Vorrichtung kann ganz aus keramischem Material aufgebaut sein (Anspruch 2). Bewährt, weil unproblematisch herstellbar, hat sich ein für die Prozeßbedingungen geeignete Edelstahllegierung für die Ringscheiben, den Substrathalter und die Getriebeschnecke (Anspruch 3).

Kugeln aus keramischem Material wie Al₂O₃ erfüllen die notwendige mechanische Anforderung, wie Härte und Abriebfestigkeit, als auch die schlechte thermische Leitfähigkeit zur thermischen Entkopplung (Ansprüche 5 und 6).

Eine reibungstechnisch günstige Gestaltung der Ringnuten ist derart, daß die Kugeln in einer Ringnut höchstens mit zwei Punkten darin aufliegen und daher höchstens auf zwei Linien pro Ringnut abrollen (Anspruch 1). In Anspruch 4 ist die geometrisch und herstellungstechnisch einfachste V-Form gekennzeichnet. Grundsätzlich wäre ein Öffnungswinkel zwischen Null und 180° denkbar, da in einer solchen Form eine Kugel darin zweipunktartig aufliegt, bzw. auf zwei Linien abrollt. Die Kugellagerfunktion soll bei allen Prozeßbedingungen reibungslos und zuverlässig bestehen. Die Kugel muß bei allen Temperaturen in der V-förmigen Nut an den Schenkelflächen liegen, sie darf nicht an der obersten Kante anliegen. Sie muß aber auch weit genug aus der Nut herausragen, um gleichartig in der andern v-förmigen Nut des Laufbetts einzuliegen. Der Öffnungswinkel liegt daher zwischen 60 und 120°.

Die Antriebswelle, die mit ihrem Endbereich im Lagerbock lagert, ist ebenfalls aus Edelstahl und wird über Gleitlager aus Keramik in Position gehalten. Sie könnte in ihrem Endbereich auch aus Keramik sein, wenn das zur konsequenten, völligen thermischen Entkopplung des Substratträgers zweckmäßig wäre. Um den konstruktiven Aufbau im Prozeßraum variabel zu halten, hat die Antriebswelle mindestens ein Kreuzgelenk und koppelt dadurch problemlos über eine Kupplung an eine Drehdurchführung in der Wand des Prozeßraums an.

Die Vorrichtung läßt eine freistehende Rotation des Substrathalters zu, d. h. das Substrat ist mit seinen beiden zu beschichtenden Trägerflächen stets ohne Hindernis exponiert. Damit können beide Trägerflächen gleichzeitig beschichtet werden, und die Nachteile des Belüftens des Prozeßraums mit all seinen Folgen entfallen.

Die Erfindung wird im folgenden anhand der Zeichnung für den simultanen, beidseitigen Beschichtungsprozeß näher erläutert. Die Zeichnung besteht aus drei Figuren. Es zeigen:
- Figur 1: die Vorrichtung in der Seitenansicht,
- Figur 2: die Vorrichtung im Schnitt und
- Figur 3: die Vorrichtung im Prozeßraum.

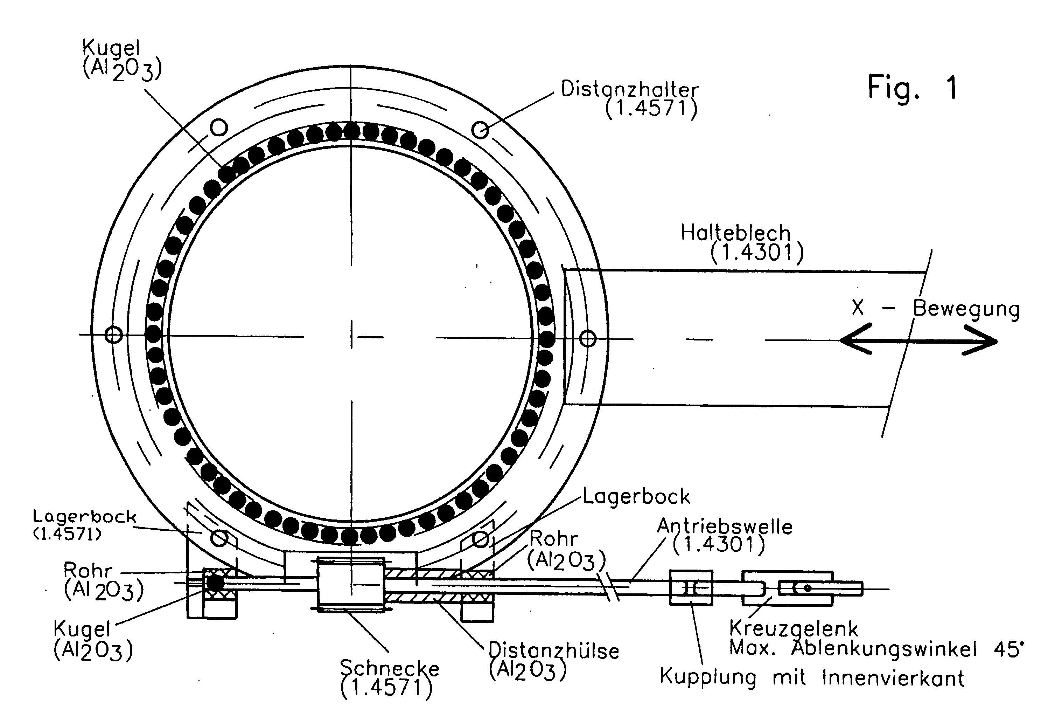

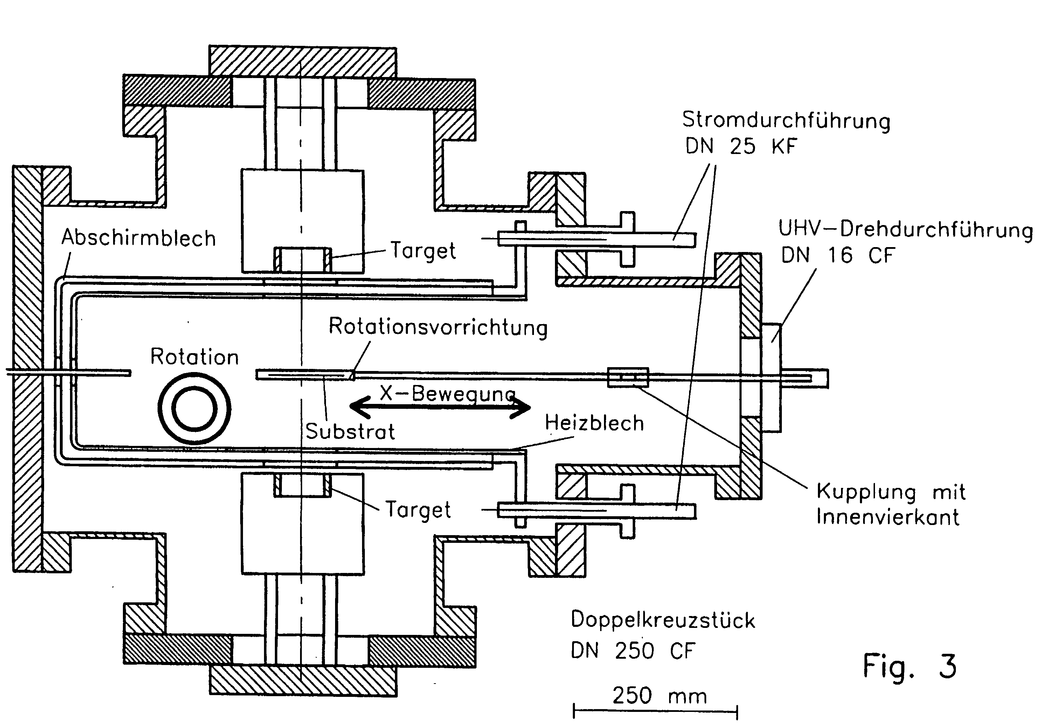

Der Prozeßraum wird durch das Doppelkreuzstück DN 250 CF aus Edelstahl gebildet. Die Vorrichtung zum Rotieren ist in der Draufsicht entlang der Längsachse der Figur 3 untergebracht. Die Drehachse des Substrathalters liegt in der Querachse des Doppelkreuzstücks. Die Halterung zur translatorischen Bewegung (x-Bewegung) der Vorrichtung liegt entlang der Längsachse des Prozeßraums (Figur 1). Damit wird durch zusätzliches Rotieren des Substrathalters jeder Punkt der beiden exponierten Flächen erreicht.

Über dem Lagerbock (Figuren 1 und 3) sitzt die Vorrichtung in dem Abschirmgehäuse mit Heizblech, das im Bereich der einander spiegelbildlich auf der Querachse gegenüberliegenden beiden Targets hinternisfrei geöffnet ist. Die beiden Targets sind Zylinderkathoden. Die Heizung ist über die beiden UHV-Stromdurchführungen DN 25 KF an die externe Stromversorgung angeschlossen.

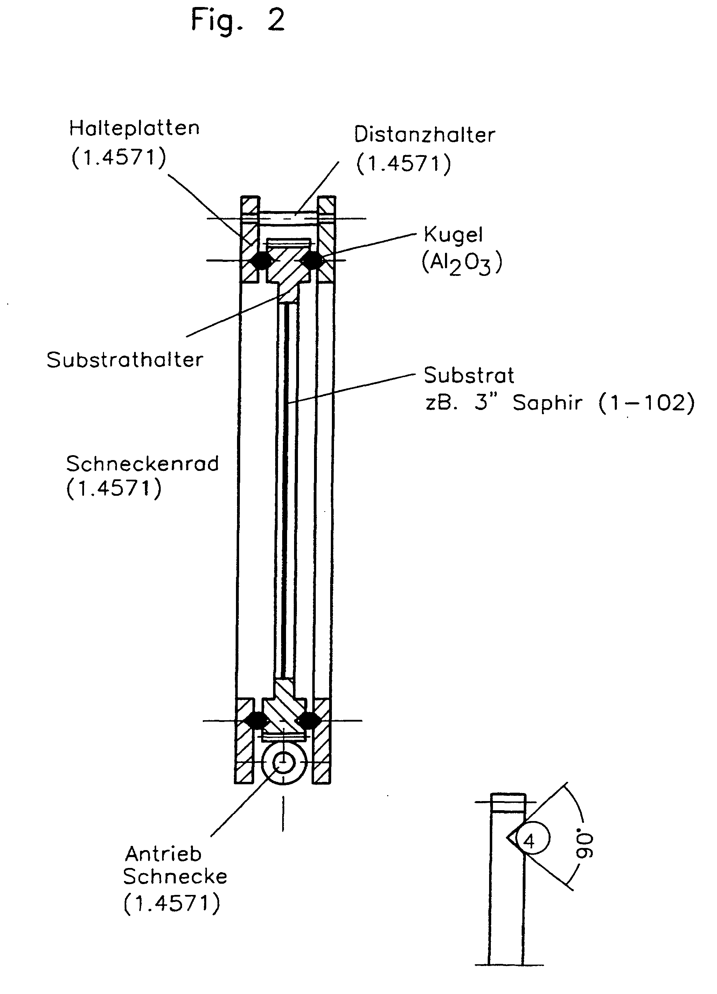

Figur 1 zeigt die Konstruktion der Vorrichtung von der Seite, Figur 2 zeigt nur den reinen Aufbau des Kugellagers im senkrechten Schnitt dazu. Die beiden Ringscheiben sind aus prozeßtauglichem Edelstahl, einer Chrom-Nickel-Legierung gemäß dem Stahlschlüssel 1.4571, die gewissermaßen die beiden Außenschalen des Kugellagers bilden, sind über entlang eines konzentrischen Kreises gleichverteilte Distanzhalter aus Edelstahl (1.4571) zueinander ebenfalls konzentrisch positioniert und bilden mit den auf beiden Seiten des Substrathalters ebenfalls aus Edelstahl (1.4571) einander gegenüberliegenden, v-förmige Ringnuten zwei Laufbette für die Kugeln aus der Keramik AL₂O₃, die denselben stets konzentrisch dazu und drehbar darin halten. Die V-Form hat hier einen Öffnungswinkel von 90° und ist so tief, daß die Kugeln an den Schenkelwänden abrollen, aber über den halben Durchmesser hinaus aus der Ringnut überstehen. Mit einem Öffnungswinkel um die 90° lassen sich die notwendigen Toleranzen für die thermischen Dehnungen erfahrungsgemäß einfach einhalten.

Die Halterung für die translatorische Positionierung besteht aus dem Halteblech aus Edelstahl (1.4301), das an dem auf der Längsachse des Doppelkreuzstücks DN 250 CF liegenden Distanzhalter oder den beiden Ringscheiben ankert.

Unten in Figur 1, an den Ringscheiben, bzw. an zwei dortigen Distanzhalter ankert der Lagerbock mit seinen beiden hochragenden Armen aus Edelstahl (1.4571). Die Antriebswelle ist aus Edelstahl (1.4301) und lagert mit ihrem Endbereich in den beiden Armen. Das geschieht über die zwei Gleitlagerhülsen aus der Keramik Al₂O₃. Die Stirn der Antriebswelle stößt auf die Keramikkugel aus Al₂O₃. Diese Lagerung benötigt keine Schmierung und gleitet bei allen Prozeßtemperaturen.

Zwischen beiden Gleitlagern sitzt die Getriebeschnecke aus Edelstahl (1.4571) auf der Antriebswelle und greift in den Zahnkranz auf der Matelfläche des Substrathalters ein. Sie wird über die Distanzhülse aus Al₂O₃ in dieser Position gehalten.

Die Antriebswelle hat auf dem Weg zum Antrieb zwei Kreuzgelenke, um zumindest einen parallelen Versatz der Wellenteile einrichten zu können. Das verschafft Freiheit für die Prozeßraumdurchführung.

Weitere, für den Beschichtungsprozeß technisch notwendige Einrichtungen, wie Vakuum-, Stromversorgungs-, Meßkomponenten und dergleichen, sind zur Wahrung der Übersicht nicht mehr eingezeichnet.

## Patentansprüche

1. Vorrichtung zum Rotieren eines mit keramischen und metallischen Substanzen zu beschichtenden Substrats in einem Prozeßraum in einer bis zur höchsten Betriebstemperatur warmen Umgebung unter 1x10⁻⁶ mbar bis zu einer Atmosphäre vorgegebener Art von 1 bar Druck, bestehend aus:
- zwei gleichen, konzentrisch zueinander liegenden Ringscheiben aus mindestens bis zur höchsten Betriebstemperatur formstabilem, chemisch inertem Material, die über Distanzhalter zueinander auf Abstand gehalten sind, in denen jeweils eine konzentrische Ringnut mit v-förmigem Querschnitt ist, und beide Ringnuten einander gegenüberliegen,
- einem ringförmigen Substrathalter aus mindestens bis zur höchsten Betriebstemperatur formstabilem, chemisch inertem Material, an dessen beiden Stirnseiten je eine gleichartige Ringnut wie in den Ringscheiben eingelassen ist, und einem Zahnkranz auf der Mantelfläche des Substrathalters,
- Kugeln aus einem mindestens bis zur höchsten Betriebstemperatur formstabilem, abriebfestem und chemisch inertem Material, die schlecht wärmeleitend sind und die in den einander gegenüberliegenden, ein Laufbett bildenden Ringnuten rollen und dabei jede Kugel die jeweilige Ringnut höchstens an zwei Punkten berührt,
so daß ein zweiseitiges kugellager aus zwei Ringscheiben, zwischen denen sich der ringförmige Substrathalter, durch Kugeln von beiden getrennt, drehen kann, gebildet wird
- einem an den beiden Ringscheiben angebrachten Lagerbock, in dem eine von der Umgebungstemperatur bis zur höchsten Betriebstemperatur belastbare Antriebswelle endet, auf der eine Getriebeschnecke aufsitzt, die über eine Distanzhülse im Bereich des Lagerbocks derart in Position gehalten wird, daß sie in den Zahnkranz eingreift,
- einem an den Ringscheiben befestigten Haltearm, mit dem die Vorrichtung senkrecht zu der Drehachse des Substrathalters bewegt wird.

2. Vorrichtung nach Anspruch 1,
**dadurch gekennzeichnet, daß**
die beiden Ringscheiben, der Substrathalter und die Getriebeschnecke aus einem abriebfesten keramischen Material sind.

3. Vorrichtung nach Anspruch 1,
**dadurch gekennzeichnet, daß**
die beiden Ringscheiben, der Substrathalter und die Getriebeschnecke aus einer abriebfesten Metallegierung wie Edelstahl sind.

4. Vorrichtung nach den Ansprüchen 2 und 3,
**dadurch gekennzeichnet, daß**
die Kugeln aus einem keramischen Material sind.

5. Vorrichtung nach Anspruch 4,
**dadurch gekennzeichnet, daß**
die Kugeln aus Al₂O₃ sind.

## Claims

1. Device for rotating a substrate, which is to be coated with ceramic and metallic substances in a process compartment in an environment heated up to the maximum operating temperature under 1 x 10⁻⁶ mbar, up to an atmosphere of a given kind of 1 bar pressure, consisting of
- two identical ring wheels positioned concentric relative to each other, out of a material dimensionally stable and chemically inert at least up to the maximum operating temperature, which are held at a distance relative to each other by means of spacers each containing a concentric annular groove of a v-shaped cross section, and with the two annular grooves situated opposite each other;
- a ring-shaped substrate holder out of a material dimensionally stable and chemically inert at least up to the maximum operating temperature, the two faces of which each carry an annular groove identical to those in the ring wheels, and a gear ring on the surface area of the substrate holder;
- spheres, out of a material dimensionally stable, wear resistant and chemically inert at least up to the maximum operating temperature, which have a low thermal conductivity, and which run in the annular grooves positioned opposite each other and constituting a race, with each sphere touching the respective annular groove at not more than two points in such a way as to constitute a two-sided ball bearing consisting of two ring wheels between which the ring-shaped substrate holder, which is separated from the two ring wheels by spheres, is able to turn;
- a bearing block, attached to the two ring wheels, in which a drive shaft accommodating temperatures between ambient temperature and the maximum operating temperature ends which carries a worm gear held in position in the area of the bearing block by a distance sleeve in such a way as to engage in the gear ring;
- a support arm attached to the ring wheels by means of which the device is moved normal to the axis of rotation of the substrate holder.

2. Device as claimed in Claim 1,
in which the two ring wheels, the substrate holder, and the worm gear are made out of a wear-resistant ceramic material.

3. Device as claimed in Claim 1,
in which the two ring wheels, the substrate holder, and the worm gear are made out of a wear-resistant metal alloy, such as stainless steel.

4. Device as claimed in Claims 2 and 3,
in which the spheres are made out of a ceramic material.

5. Device as claimed in Claim 4,
in which the spheres are made out of Al₂O₃.

## Revendications

1. Dispositif de rotation d'un substrat à revêtir de matières céramiques et métalliques fonctionnant dans un volume de traitement en milieu chaud, à des températures allant jusqu'à la température de service maximale, sous 1 x 10⁻⁶ mbar jusqu'à une atmosphère de nature prédéfinie, à une pression de 1 bar, et qui se compose de:
- deux disques annulaires identiques, concentrique l'un par rapport à l'autre, d'un matériau indéformable du moins jusqu'à la température de service maximale, chimiquement inerte, dont l'espacement est assuré par des écarteurs, chacun desquels contenant une rainure annulaire concentrique à section en v, les deux rainures étant opposées l'une à l'autre,
- d'un support de substrat annulaire en matériau indéformable du moins jusqu'à la température de service maximale, chimiquement inerte, une rainure similaire à celles des disques annulaires étant disposée sur chacune des deux faces dudit support dont l'enveloppe est munie d'une couronne dentée,
- de billes d'un matériau indéformable du moins jusqu'à la température de service maximale, résistant à l'usure et chimiquement inerte, de mauvaise conductibilité thermique et qui roulent dans les rainures annulaires opposées les unes aux autres, formant un lit de roulement, chaque bille étant en contact avec la rainure annulaire respective à deux endroits au maximum, de sorte qu'un roulement à billes à deux côtés est formé, composé de deux disques annulaires entre lesquels le support de substrat annulaire peut tourner, séparé des deux disques par des billes,
- d'un support de palier disposé sur les deux disques annulaires, dans lequel se termine un arbre d'entraînement pouvant supporter des températures allant de l'ambiante jusqu'à la température de service maximale, sur lequel repose un vis d'engrenage tenu en position par une douille d'écartement au niveau du support de palier de manière à s'engrener dans la couronne dentée,
- d'un bras de support fixé sur les disques annulaires et qui sert à mettre en mouvement le dispositif dans le sens perpendiculaire à l'axe de rotation du support de substrat.

2. Dispositif selon la revendication 1,
**caractérisé en ce que**
les deux disques annulaires, le support de substrat et le vis d'entraînement sont en matériau céramique résistant à l'usure.

3. Dispositif selon la revendication 1,
**caractérisé en ce que**
les deux disques annulaires, le support de substrat et le vis d'entraînement sont en alliage métallique résistant à l'usure tel qu'un acier allié.

4. Dispositif selon les revendications 2 et 3,
**caractérisé en ce que**
les billes sont en matériau céramique.

5. Dispositif selon la revendication 4,
**caractérisé en ce que**
les billes sont en Al₂O₃.
